**Europäisches Patentamt**

**European Patent Office**

**Office européen des brevets**

(11) Veröffentlichungsnummer: **0 257 326**
**A2**

# (12) EUROPÄISCHE PATENTANMELDUNG

(21) Anmeldenummer: **87110948.4**

(22) Anmeldetag: **28.07.87**

(51) Int. Cl.4: **H05K 13/02 , H05K 13/00**

(30) Priorität: **25.08.86 DE 3628836**

(43) Veröffentlichungstag der Anmeldung:
**02.03.88 Patentblatt 88/09**

(84) Benannte Vertragsstaaten:
**CH DE FR GB IT LI SE**

(71) Anmelder: **Siemens Aktiengesellschaft Berlin und München**
**Wittelsbacherplatz 2**
**D-8000 München 2(DE)**

(72) Erfinder: **Sydow, Manfred**
**Mozartstrasse 21**
**D-6720 Speyer(DE)**
Erfinder: **Flügel, Roland**
**Iptestal 2 A**
**D-6734 Lambrecht(DE)**
Erfinder: **Gruber, Helmut**
**Hirschstrasse 25**
**D-6720 Speyer(DE)**

(54) **Vorrichtung zur Bereitstellung von elektrischen Bauelementen für einen Bestückungsautomaten.**

(57) Die in die gleiche Richtung weisenden Anschlußelemente (4) eines elektrischen Bauelementes (1) werden in der Vorrichtung (3) von einem Spreizstempel (10) auseiandergespreizt. Anschließend wird das Bauelement (1) in eine Entnahmestellung geschwenkt, in der die Anschlußelemente (4) von Greiffingern (13) eines Handhabungsroboters auf einen Sollabstand zurückgebogen werden. Die derartig gegriffenen Bauelemente werden der Vorrichtung (3) entnommen und auf eine zu bestückende Leiterplatte aufgesetzt.

## FIG 2

## Vorrichtung zur Bereitstellung von elektrischen Bauelementen für einen Bestückungsautomaten

Die Erfindung bezieht sich auf eine Vorrichtung zur Durchführung eines Verfahrens zum automatisierten Einsetzen von in die gleiche Richtung weisenden Anschlußelementen eines elektrischen Bauelementes in Öffnungen eines Trägerteiles mittels eines Greifers, der das Bauelement an seinen Anschlußelementen in der Nähe von deren freien Enden ergreift, gemäß der deutschen 35 13 679, wonach die Anschlußelemente vor dem Greifvorgang leicht auseinandergespreizt angeordnet werden und wonach der Greifer die Anschlußelemente von außen umgreift und deren freie Enden auf ein gewünschtes Maß zusammendrückt.

Durch das Spreizen und Zusammendrücken der Anschlußelemente entsteht zu den Greiffingern eine Federspannung, durch die das Bauelement eingeklemmt gehalten werden kann.

Der Erfindung liegt die Aufgabe zugrunde, eine einfache Vorrichtung zu schaffen, die ein genaues Spreizen und Zurückbiegen der Anschlußelemente sowie das Entnehmen durch den Greifer ermöglicht.

Diese Aufgabe wird durch die Erfindung gemäß Anspruch 1 gelöst. Durch den in der Richtung der Anschlußelemente verschiebbaren Stempel können alle Anschlußelemente gleichzeitig in eine definierte Spreizstellung verbogen werden. Da die Lage der Spreizflächen auf diese Biegestellung abgestimmt ist, läßt sich diese mit geringem Aufwand einstellen. Durch die Gestaltung der Gegenlage und der Freimachungen kann der Greifer die Anschlußelemente ergreifen, ohne daß zuvor das Bauelement aus der Vorrichtung herausgehoben werden muß.

Vorteilhafte Weiterbildungen der Erfindung sind in den Ansprüchen 2 bis 6 gekennzeichnet:

Durch die Weiterbildung nach Anspruch 2 ist das Bauelement weitgehend frei zugänglich.

Durch die Weiterbildung nach Anspruch 3 wird die Gegenlage konstruktiv vereinfacht.

Die Weiterbildung nach Anspruch 4 ermöglicht das stirnseitige Umfassen des Bauelementes sowie dessen einfache Entnahme. Die Aufnahme ist z.B. um 90° verschwenkbar, was sich in einfacher Weise mittels eines Druckluftzylinders bewerkstelligen läßt.

Durch die Weiterbildung nach Anspruch 5 wird das Bauelement sicher in die Vorrichtung eingeführt und an dem Anschlag gehalten.

Die Weiterbildung nach Anspruch 6 ermöglicht einen einfachen Aufbau der Vorrichtung.

Im folgenden wird die Erfindung anhand eines in der Zeichnung dargestellten Ausführungsbeispieles näher erläutert.

Es zeigen:

Fig. 1 eine Seitenansicht einer Vorrichtung zur Bereitstellung von elektrischen Bauelementen für einen Bestückungsautomaten mit einem Biegestempel zum Auseinanderspreizen von Anschlußelementen der Bauelemente,

Fig. 2 die Vorrichtung nach Fig. 1 in einer Phase nach dem Biegen der Anschlußelemente,

Fig. 3 die Vorrichtung nach Fig. 2 in einer Entnahmestellung,

Fig. 4 eine andere Seitenansicht der Vorrichtung nach Fig. 3 mit Greiffingern eines Greifers für die Bauelemente,

Fig. 5 die Vorrichtung nach Fig. 4 mit den Greiffingern in der Greifposition.

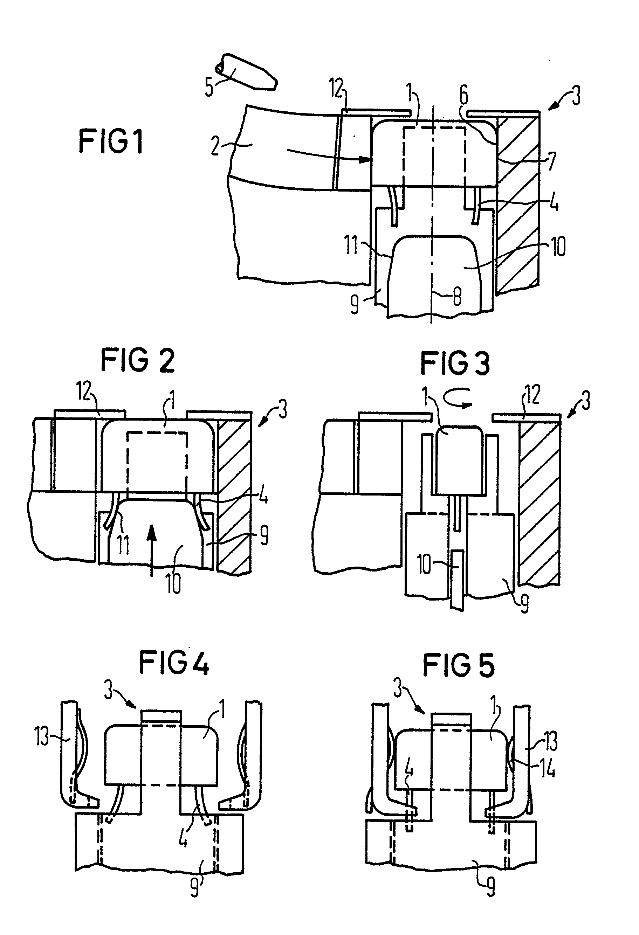

Nach Fig. 1 ist ein elektrisches Bauelement 1 entlang einer Führungsbahn 2 gemäß dem dargestellten Pfeil in eine Vorrichtung zum Auseinanderspreizen von nach unten gerichteten Anschlußelementen 4 des Bauelementes 1 eingeführt. Oberhalb der Führungsbahn 2 ist eine Druckluftdüse 5 angeordnet, die in die Richtung des eingeführten Bauelementes 1 zeigt. Dieses liegt mit seiner der Düse abgewandten voreilenden Stirnseite 6 an einem festen Anschlag 7 der Vorrichtung 3 an. Das Bauelement 1 liegt mit seiner Unterseite an einer um eine Achse 8 schwenkbaren Aufnahme 9 auf, die das Bauelement 1 längsseitig klauenförmig umgreift. In der Richtung der zu den stiftartigen Anschlußelementen 4 parallelen Achse 8 ist auf die Anschlußelemente 4 zu ein Spreizstempel 10 verschiebbar, der in der Aufnahme 9 geführt ist. Der Spreizstempel 10 ist mit Spreizflächen 11 versehen, deren Lage den Anschlußelementen 4 angepaßt ist. Die Vorrichtung 3 weist oberhalb des Bauelementes 1 eine deren Stirnseiten überlappende zweiteilige Gegenlage 12 auf, die einen Zwischenraum von mehr als der Breite des Bauelementes 1 frei läßt.

Nach Fig. 2 ist der Spreizstempel 10 gemäß dem Pfeil zwischen die Anschlußelemente 4 gedrückt, wobei seine Spreizflächen 11 entsprechend ihrer keilförmigen Anordnung die Anschlußelemente 4 an ihren freien Enden auseinandergespreizt haben. Bei diesem Vorgang stützt sich Bauelement 1 mit seiner Oberseite an der Gegenlage 12 ab.

Nach Fig. 3 ist die Aufnahme 9 mit dem Spreizstempel 10 und dem Bauelement 1 um die Achse 8 (Fig. 1) um 90° verdreht worden. Die Vorrichtung 3 ist seitlich offen, so daß das Bauelement 1 von oben und stirnseitig zugänglich ist. Der z.B. pneumatisch betätigte Spreizstempel 10 ist vor dem Verdrehen in seine Ausgangsstellung zurückgezogen worden.

Nach Fig. 4 sind zwei Greiffinger 13 eines Greifers eines Handhabungsroboters stirnseitig an das in der Vorrichtung 3 befindliche Bauelement 1 herangeführt. Sie befinden sich mit ihren freien Enden neben den Anschlußelementen 4 und sind auf diese zu bewegbar.

Nach Fig. 5 sind die Anschlußelemente 4 durch die Greiffinger 13 auf einen definierten Sollabstand zurückgebogen. Das Bauelement 1 wird hauptsächlich aufgrund der Rückfederspannung der Anschlußelemente 4 an diesen gehalten. Zusätzlich sind an den Greiffingern 13 noch Klemmfedern 14 angebracht, die das Bauelement 1 stirnseitig halten.

## Ansprüche

1. Vorrichtung zur Durchführung eines Verfahrens zum automatisierten Einsetzen von in die gleiche Richtung weisenden Anschlußelementen (4) eines elektrischen Bauelementes (1) in Öffnungen eines Trägerteiles mittels eines Greifers, der das Bauelement (1) an seinen Anschlußelementen (4) in der Nähe von deren freien Enden ergreift, wobei die Anschlußelemente (4) vor dem Greifvorgang leicht auseinandergespreizt angeordnet werden und der Greifer die Anschlußelemente (4) von außen umgreift und deren freie Enden auf ein gewünschtes Maß zusammendrückt,

**dadurch gekennzeichnet,**

daß für die Anschlußelemente (4) ein Spreizstempel (10) mit schrägen Spreizflächen (11) vorgesehen ist, die in ihrem Abstand zueinander dem Abstand der Anschlußelemente (4) entsprechen, daß der Spreizstempel (10) in Richtung der Anschlußelemente (4) auf diese zu bewegbar ist, daß das Bauelement (1) beim Biegen mit seiner den Anschlußelementen (4) abgewandten Seite an einer Gegenlage (12) der Vorrichtung abgestützt ist und daß die Vorrichtung (3) seitliche Freimachungen für Greiffinger (13) des Greifers aufweist.

2. Vorrichtung nach Anspruch 1,

**dadurch gekennzeichnet,**

daß die Gegenlage (12) das quaderförmige Bauelement (1) im Bereich seiner Ecken überlappt.

3. Vorrichtung nach Anspruch 2,

**dadurch gekennzeichnet,**

daß das schlanke Bauelement im Bereich seiner Stirnseiten überlappt ist.

4. Vorrichtung nach Anspruch 2 oder 3,

**dadurch gekennzeichnet,**

daß das Bauelement (1) in seiner Längsrichtung der Vorrichtung (3) zuführbar ist und mit seiner voreilenden Stirnseite (6) an einem Anschlag (7) der Vorrichtung anschlägt, daß das Bauelement (1) längsseitig in einer schwenkbaren Aufnahme (9) geführt ist, die das Bauelement (1) von der Seite der Anschlußelemente (4) her klauenförmig umgreift, daß die Gegenlage (12) das Bauelement (1) in der Zuführstellung überlappt und daß nach dem Spreizen der Anschlußelemente (4) die Aufnahme (9) mit dem Bauelement (1) in eine Entnahmestellung verdrehbar ist, in der die Greiffinger (13) des Greifers das Bauelement (1) von seinen Stirnseiten her an den Anschlußelementen (4) erfassen und diese in ihre Sollstellung zurückbiegen und das Anschlußelement (1) der Vorrichtung (3) entnehmen kann.

5. Vorrichtung nach Anspruch 4,

**dadurch gekennzeichnet,**

daß das Bauelement (1) aus der Zuführrichtung mit Druckluft beaufschlagbar ist.

6. Vorrichtung nach Anspruch 4 oder 5,

**dadurch gekennzeichnet,**

daß der Biegestempel (10) in der Aufnahme (9) geführt und mit dieser verdrehbar ist.

FIG 1

FIG 2

FIG 3

FIG 4

FIG 5